# EUROPEAN PATENT APPLICATION

(11) **EP 4 675 893 A1**
(43) Date of publication of application: **07.01.2026**
(21) Application number: 25723579.6
(22) Date of filing: 25.04.2025
(51) Int. Cl.: H02J 50/80, H02J 50/12, G01R 19/165

(54) **ELECTRONIC DEVICE AND METHOD FOR SETTING REFERENCE VALUE FOR DETECTION**

(30) Priority: 14.05.2024 KR 20240063070; 10.06.2024 KR 20240075341
(71) Applicant: Samsung Electronics Co., Ltd., Suwon-si, Gyeonggi-do 16677 (KR)
(72) Inventor: HA, Mincheol, Suwon-si, Gyeonggi-do 16677 (KR); KIM, Dongzo, Suwon-si, Gyeonggi-do 16677 (KR); YU, Taehyeon, Suwon-si, Gyeonggi-do 16677 (KR); LEE, Kyungmin, Suwon-si, Gyeonggi-do 16677 (KR)
(74) Representative: HGF
(86) International application number: PCT/KR2025/005651
(87) International publication number: WO 2025/239582

(57) **Abstract**

An electronic device is disclosed. The electronic device may comprises wireless power supply circuitry configured to wirelessly supply power, and a controller comprising processing circuitry, and configured to: transmit first analog pings in a predetermined time interval, the first analog pings each having a first duration; identify a representative current value based on first current values of the first analog pings; identify a reference current value based on the representative current value; transmit a second analog ping having the first duration; identify a second current value of the second analog ping; based on the second current value exceeding the reference current value, transmit a digital ping with a second duration longer than the first duration; and based on the second current value being less than or equal to the reference current value, transmit a third analog ping with the first duration.

## Description

### [Technical Field]

The following descriptions relate to an electronic device and a method for setting a reference value for detection.

### [Background Art]

Recently, with development of digital technology, various types of electronic devices such as a mobile communication terminal, a smart phone, a tablet personal computer (PC), a personal digital assistant (PDA), an electronic notebook, a notebook, or a wearable device are widely used.

An electronic device generally uses a battery for portability. A charging method of the battery of the electronic device may be divided into a wired charging method and a wireless charging method. For example, the wireless charging method of the electronic device may be divided into a contact charging method that charges the battery through electrical contact and a contactless charging method that charges the battery using magnetic coupling without electrical contact.

The wireless charging method may be based on a wireless power transfer technology. The wireless power transfer technology may refer to technology in which electrical power is wirelessly transferred from a power transmission device to a power reception device without a connection through separate hardware (e.g., a universal serial bus (USB) connector) between the power reception device and the power transmission device. Through the wireless power transfer technology, the power reception device may charge a battery of the power reception device. The wireless power transfer technology may include a magnetic induction method and a magnetic resonance method, and may also include various types of wireless power transfer technology.

The technical problems to be achieved in this document are not limited to those described above, and other technical problems not mentioned herein will be clearly understood by those having ordinary knowledge in the art to which the present invention belongs, from the following description.

### [Disclosure]

### [Technical Solution]

An electronic device is disclosed. The electronic device may comprise wireless power supply circuitry configured to wirelessly supply power, and a controller comprising processing circuitry, and configured to: transmit first analog pings in a predetermined time interval, the first analog pings each having a first duration; identify a representative current value based on first current values of the first analog pings; identify a reference current value based on the representative current value; transmit a second analog ping having the first duration; identify a second current value of the second analog ping; based on the second current value exceeding the reference current value, transmit a digital ping with a second duration longer than the first duration; and based on the second current value being less than or equal to the reference current value, transmit a third analog ping with the first duration.

A method of an electronic device including wireless power supply circuitry configured to wirelessly supply power is disclosed. The method may comprise transmitting first analog pings in a predetermined time interval, the first analog pings each having a first duration; identifying a representative current value based on first current values of the first analog pings; identifying a reference current value based on the representative current value; transmitting a second analog ping having the first duration; identifying a second current value of the second analog ping; based on the second current value exceeding the reference current value, transmitting a digital ping with a second duration longer than the first duration; and based on the second current value being less than or equal to the reference current value, transmitting a third analog ping with the first duration.

### [Description of the Drawings]

In connection with a description of the drawings, the same or similar reference numerals may be used for the same or similar components.
FIG. 1A is a block diagram of electronic devices for wireless charging, according to an embodiment.
FIG. 1B is a block diagram of an electronic device for wireless charging, according to an embodiment.
FIG. 2 is a diagram illustrating an example of states of an electronic device according to an embodiment.
FIG. 3A is a diagram illustrating timings of pings transmitted by an electronic device for detection of an external electronic device according to an embodiment.
FIG. 3B is a diagram exemplifying a signal for supplying electrical power to an external electronic device by an electronic device according to an embodiment.
FIG. 4 is a diagram exemplifying a graph for a gain according to a frequency.
FIG. 5A is a diagram exemplifying an error that may occur in case that a resonance frequency is set high.
FIG. 5B is a diagram exemplifying an error that may occur in case that a resonance frequency is set low.
FIG. 6 is a flowchart exemplifying an operation of an electronic device according to an embodiment.
FIG. 7 is a block diagram of an electronic device in a network environment according to various embodiments.

### [Mode for Invention]

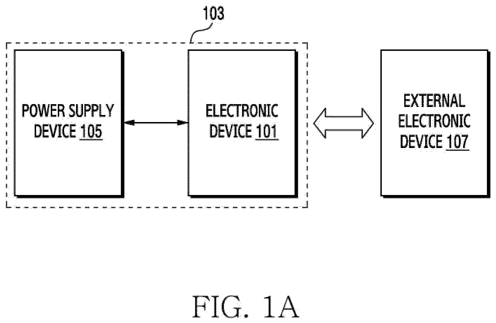

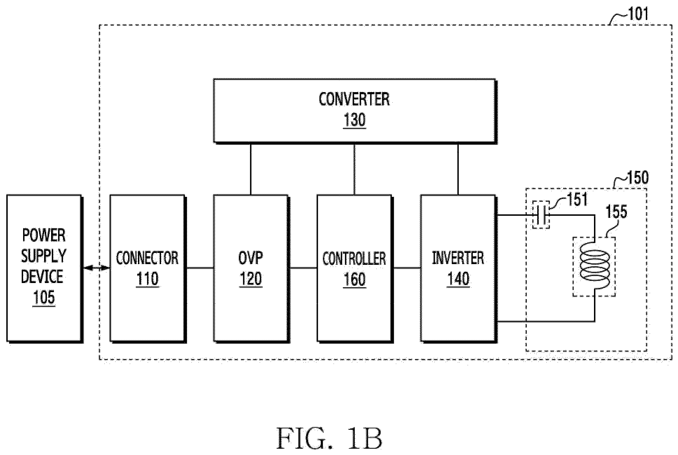

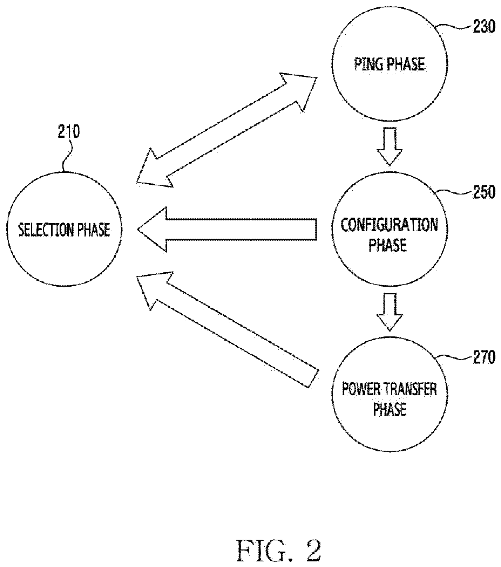

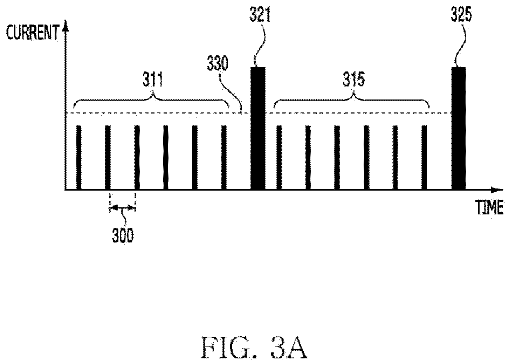

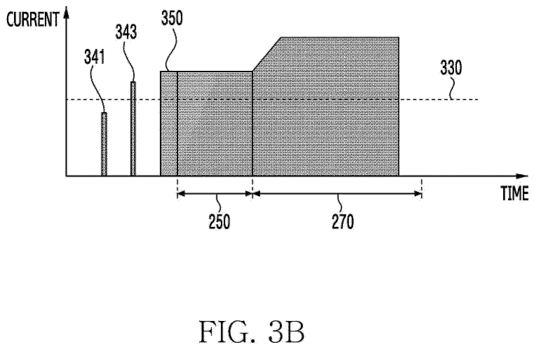

FIG. 1A is a block diagram of electronic devices for wireless charging, according to an embodiment. FIG. 1B is a block diagram of an electronic device for wireless charging, according to an embodiment. FIG. 2 is a diagram illustrating an example of states of an electronic device according to an embodiment. FIG. 3A is a diagram illustrating timings of pings transmitted by an electronic device for detection of an external electronic device according to an embodiment. FIG. 3B is a diagram exemplifying a signal for supplying electrical power to an external electronic device by an electronic device according to an embodiment.

In an embodiment, an electronic device 101 may be a device (e.g., a wireless charging pad or a smartphone) that may wirelessly provide electrical power to another device (e.g., an external electronic device 107).

In an embodiment, a power supply device 105 may be a device (e.g., a travel adapter (TA) or a power supply) that may provide or supply electrical power to another device (e.g., the electronic device 101 and/or the external electronic device 107) by wire. In an embodiment, the electronic device 101 and the power supply device 105 may be separate devices. For example, the electronic device 101 and the power supply device 105 may be included in each of separate housings. However, it is not limited thereto. For example, the electronic device 101 and the power supply device 105 may be one wireless power supply device 103. For example, the electronic device 101 and the power supply device 105 may be included in one housing.

In an embodiment, the external electronic device 107 may be a device (e.g., a mobile device) for charging a rechargeable battery (not illustrated) of the external electronic device 107 through electrical power obtained from the outside. That is, the external electronic device 107 may comprise a battery and be configured to charge the battery using power obtained from another entity, e.g. power supplied to the external electronic device 107. For example, a mobile device may include a smartphone, a wireless earphone, or a wearable device (e.g., a smart watch, a smart ring, a head mounted display (HMD)).

Referring to FIG. 1B, the electronic device 101 may include a connector 110, over voltage protection (OVP) circuitry 120, a converter 130, an inverter 140, wireless power supply circuitry 150, and a controller 160. It will be appreciated that, in various examples in accordance with FIG. 1B, the electronic device may include one or more of a connector 110, over voltage protection (OVP) circuitry 120, a converter 130, an inverter 140, wireless power supply circuitry 150, or a controller 160.

In an embodiment, in order to wirelessly supply DC power from the power supply device 105 to AC power to the external electronic device 107, the electronic device 101 may wirelessly supply the AC power to the external electronic device 107, by converting the DC power into the AC power through the connector 110, the over voltage protection (OVP) circuitry 120, the converter 130, the inverter 140, and/or the wireless power supply circuitry 150. For example, the electronic device 101 may generate AC power of a fixed frequency through the inverter 140. For example, a specified frequency (e.g., the fixed frequency) may correspond to a resonance frequency of the wireless power supply circuitry 150. For example, the AC power of the fixed frequency generated through the inverter 140 may be proportional to an output voltage (or an input voltage (or a drain voltage) of the inverter 140) of the converter 130. For example, the AC power proportional to the output voltage of the converter 130 (or the input voltage (or the drain voltage) of the inverter 140), or at least a portion thereof, may be wirelessly supplied to the external electronic device 107. However, it is not limited thereto. For example, the electronic device 101 may convert DC power of the converter 130 into AC power having a variable frequency other than the specified frequency (e.g., the fixed frequency) through the inverter 140. For example, the AC power of the variable frequency generated through the inverter 140 may be inversely proportional to an operating frequency of the inverter 140. For example, the AC power inversely proportional to the operating frequency of the inverter 140 may be wirelessly supplied to the external electronic device 107. Hereinafter, a method of changing magnitude of electrical power supplied by the electronic device 101 to the external electronic device 107 may be a method of changing the input voltage inputted to the inverter 140 in a state in which the operating frequency of the inverter 140 is fixed or specified.

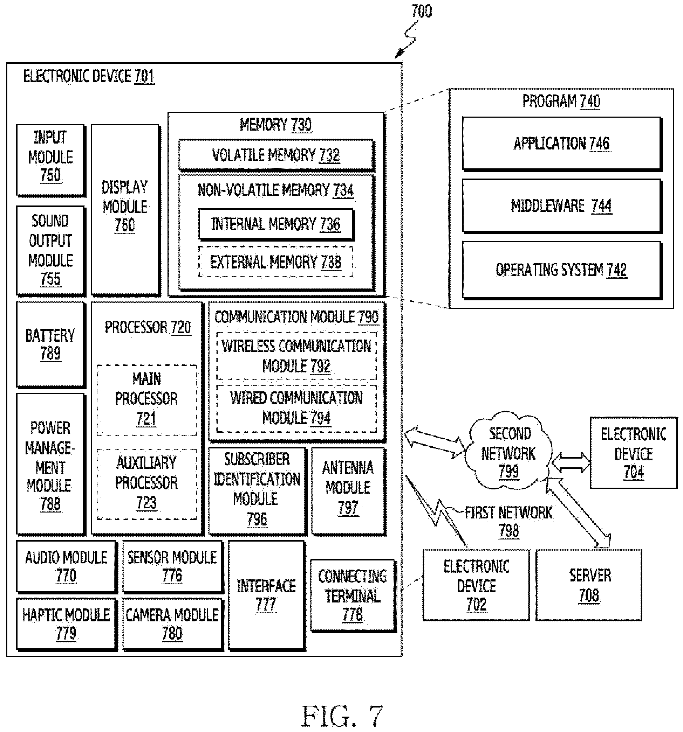

For example, the connector 110 may correspond to an interface 777 and/or a connection terminal 778 of FIG. 7. For example, the OVP circuitry 120, the converter 130, and/or the inverter 140 may be included in a power management module 788 of FIG. 7. For example, the controller 160 may correspond to a processor 720 of FIG. 7.

For example, the electronic device 101 may be wiredly connected (i.e. connected by a wire) to the power supply device 105 through a hardware interface (e.g., a universal serial bus (USB) interface) (e.g., the connector 110). In an embodiment, the electronic device 101 may obtain (e.g. receive) electrical power from the power supply device 105 through the connector 110. For example, the electronic device 101 may obtain the electrical power from the power supply device 105 wiredly connected through the USB-based connector 110. In an embodiment, the connector 110 may be physically connected to a connector (not illustrated) of the power supply device 105 through a cable. For example, the connector 110 may include an interface for obtaining the electrical power of the power supply device 105. For example, the connector 110 may include a USB interface. In various examples, the electronic device 101 may wirelessly receive power from the power supply device 105, e.g. based on an established wireless power transfer).

For example, the electronic device 101 may terminate a connection between the connector 110 and the converter 130 based on an overvoltage greater than or equal to a reference voltage (e.g., 5.9 volts) through the OVP circuitry 120. For example, the electronic device 101 may terminate the connection between the connector 110 and the converter 130 based on identifying the overvoltage greater than or equal to the reference voltage through the OVP circuitry 120, so that the electrical power from the power supply device 105 is not transmitted to the converter 130. For example, the OVP circuitry 120 may be an electronic element (or an electrical element) that terminates an electrical connection (or a physical connection) between the connector 110 and the converter 130 based on the overvoltage greater than or equal to the reference voltage.

For example, the electronic device 101 may convert the electrical power of, or from, the power supply device 105 into DC power of a specified voltage through the converter 130.

For example, the electronic device 101 may convert the electrical power of the power supply device 105 into DC power of a stepped-up voltage through the converter 130. For example, the electronic device 101 may convert the electrical power of the power supply device 105 into stepped-down DC power through the converter 130. For example, the electronic device 101 may convert the electrical power of the power supply device 105 into DC power of a stepped-down or stepped-up voltage through the converter 130. For example, the converter 130 may include circuitry for stepping up, stepping down, or maintaining a voltage of the electrical power obtained from the power supply device 105. For example, the converter 130 may be a buck-boost converter. For example, the converter 130 may be the buck-boost converter including buck circuitry and boost circuitry.

For example, the electronic device 101 may convert the DC power of, or output by, the converter 130, or at least a portion of said DC power, into the AC power through the inverter 140. For example, the electronic device 101 may convert the DC power of the converter 130 into the AC power of the specified frequency (e.g., the fixed frequency, or a first frequency) through the inverter 140. For example, the specified frequency may correspond to the resonance frequency of the wireless power supply circuitry 150. However, it is not limited thereto. For example, the electronic device 101 may convert the DC power of the converter 130 into the AC power having a frequency other than the specified frequency (e.g., the fixed frequency) through the inverter 140, e.g. into AC power having a second frequency different to the first frequency.

For example, the electronic device 101 may wirelessly supply electrical power to the external electronic device 107 through or via the wireless power supply circuitry 150. For example, the electronic device 101 may wirelessly supply electrical power to the external electronic device 107 through the wireless power supply circuitry 150 based on an electromagnetic induction method or an electromagnetic resonance method. For example, the electronic device 101 may wirelessly supply electrical power to the external electronic device 107 based on a wireless power supply technique defined in a specified protocol (e.g., a protocol defined in a wireless power consortium (WPC)). In an embodiment, the electronic device 101 that wirelessly supplies electrical power may be referred to as a power transmitter (PTx), and the external electronic device 107 that wirelessly obtains electrical power may be referred to as a power receiver (PRx).

For example, the electronic device 101 may supply electrical power to the external electronic device 107 based on the AC power of the inverter 140. In an embodiment, the wireless power supply circuitry 150 may include a capacitor 151 and an inductor 155. In an embodiment, the wireless power supply circuitry 150 may supply electrical power to the external electronic device 107 based on a resonance frequency (e.g., 90 kilohertz (kHz)) based on the capacitor 151 (e.g., 500 nano-farads (nF)) and the inductor 155 (e.g., 6.3 microhenries (uH)). According to an embodiment, the wireless power supply circuitry 150 may be referred to as wireless power supply circuitry, power transmitter circuitry or resonance circuitry.

For example, the controller 160 of the electronic device 101 may identify a charging mode (e.g., a fast charging mode by a high voltage or a general charging mode by a reference voltage) supported by the power supply device 105. For example, the controller 160 may determine whether or not the power supply device 105 supports the fast charging, based on a signal (e.g., a capabilities message) obtained from the power supply device 105 through the connector 110.

For example, the controller 160 may cause the electronic device 101 to obtain DC power of a specified voltage and/or a specified current from the power supply device 105 by transmitting a signal (e.g., a request message) indicating a voltage and/or a current (or a request for a specific voltage or current) determined based on a determination result to the power supply device 105 through the connector 110.

For example, the controller 160 may request the power supply device 105 to change a voltage and/or a current. For example, the controller 160 may request the power supply device 105 to change the voltage and/or the current based on charging power (a charging voltage and a charging current) required by the external electronic device 107. For example, the controller 160 may cause (e.g. control) the electronic device 101 to obtain DC power to which a voltage and/or a current are changed from the power supply device 105, by transmitting a signal (e.g., a request message) requesting electrical power of a voltage and/or a current (or a change thereof) corresponding to the charging power required by the external electronic device 107. For example, the change in the voltage and/or the current of the DC power from the power supply device 105 may include a change in the DC power from the power supply device 105. For example, the change in the voltage and/or the current of the DC power from the power supply device 105 may include a change in a power level (or magnitude) (or watt) of the DC power from the power supply device 105.

For example, the controller 160 may identify the external electronic device 107 based on the specified protocol (e.g., the protocol defined in the WPC) including one or more phases.

For example, referring to FIG. 2, the controller 160 may detect the external electronic device 107 in a selection phase 210. For example, the controller 160 may detect the external electronic device 107 based on one or more analog ping transmitted through the wireless power supply circuitry 150 during the selection phase 210. The analog ping may be for detecting the external electronic device 107.

For example, the controller 160 may identify a connection with the power supply device 105. For example, the controller 160 may control the power supply 105 so that the wireless power supply circuitry 150 transmits analog pings after electrical power starts to be obtained from the power supply device 105 after the connection with the power supply device 105. For example, based on a power transfer being established with the power supply device 105 or based on receiving power from the power supply device 105, the electronic device 101 (e.g. wireless power supply circuity 150 included therein) transmits or broadcasts analog pings.

For example, referring to FIG. 3A, the controller 160 may detect the external electronic device 107 based on each of analog pings 311 transmitted through the wireless power supply circuitry 150 at a specified (or predetermined, fixed, set etc.) time interval 300 (e.g., 200 milliseconds). For example, the controller 160 may detect the external electronic device 107 based on each, or one or more, of the analog pings 311 transmitted during a specified time duration (e.g., 8 milliseconds) at the specified time interval 300 (e.g., 200 milliseconds). For example, the controller 160 may determine a presence or an absence of the external electronic device 107 based on a change in electrical energy (or an electrical characteristic, e.g., at least one of a current and a voltage) measured when transmitting the analog ping during the selection phase 210. An analog ping may have a duration (or time duration, duration length, or signal length, or duration etc.), e.g. 8 milliseconds.

For example, referring to FIG. 3B, the controller 160 may determine that the external electronic device 107 is not detected based on identifying that a current value of an analog ping (e.g., an analog ping 341) is less than or equal to a threshold current value 330.

For example, referring to FIG. 3B, the controller 160 may determine that the external electronic device 107 is detected based on identifying that a current value of an analog ping (e.g., an analog ping 343) is greater than the threshold current value 330.

For example, the controller 160 may transition to a ping phase 230 based on the detection of the external electronic device 107 during the selection phase 210. However, it is not limited thereto. For example, the controller 160 may transition to the ping phase 230 in a next interval according to the time interval 300 based on transmitting the specified number (e.g., six) of the analog pings 311 during the selection phase 210.

For example, the controller 160 may wake up the external electronic device 107 (or communication circuitry (not illustrated) of the external electronic device 107) by transmitting a power signal (e.g., a digital ping) to the external electronic device 107 through the wireless power supply circuitry 150 during the ping phase 230. For example, based on detecting the external electronic device 107, the electronic device 101 is configured to transmit or broadcast one or more digital ping, for reception by the external electronic device 107. For example, a time duration (e.g., 90 milliseconds) of a digital ping 321 or 325 may be longer than a time duration (e.g., 8 milliseconds) of an analog ping 311 or 315. For example, magnitude of electrical power transmitted to the external electronic device 107 through or via the digital ping 321 or 325 may be greater than magnitude of electrical power transmitted to the external electronic device 107 through or via the analog ping 311 or 315. For example, a current value and/or a voltage value of the digital ping 321 or 325 may be the same as a current value and/or a voltage value of the analog ping 311 or 315. However, it is not limited thereto. For example, the current value and/or the voltage value of the digital ping 321 or 325 may be greater than the current value and/or the voltage value of the analog ping 311 or 315. For example, the current value of the digital ping 321 or 325 may be greater than the current value of the analog ping 311 or 315.

For example, the controller 160 may receive a packet (or a response to a digital ping) indicating signal strength from the external electronic device 107 based on the digital ping 321 or 325 transmitted through the wireless power supply circuitry 150 after the time interval 300 after an analog ping, in which the external electronic device 107 is detected, is transmitted. That is, for example, the electronic device 101 may receive a message or information from the external electronic device 107, said message or information may indicate signal strength e.g. based on the digital ping transmitted by the electronic device 101.

For example, the controller 160 may transition or return to the selection phase 210 based on not receiving the packet (or the response to the digital ping 321) indicating the signal strength from the external electronic device 107 during the ping phase 230. For example, based on the external electronic device 107 not being detected during the ping phase 230 (i.e. via digital ping), the electronic device 101 returns to the selection phase 210.

For example, referring to FIG. 3A, the electronic device 101 may detect the external electronic device 107 based on each of the analog pings 315 during the selection phase 210 transitioned based on not receiving the response to the digital ping (e.g., the digital ping 321). For example, upon returning to the selection phase 210, the electronic device 101 may detect (or again detect) the external electronic device 107 based on transmitting analog ping(s).

For example, the controller 160 may transition to a configuration phase 250 (or an identification & configuration phase) based on receiving a response to a digital ping (e.g., a digital ping 350) during the ping phase 230.

For example, the controller 160 may receive a packet indicating identification information and/or configuration information from the external electronic device 107 during the configuration phase 250. For example, the identification information may indicate identification (ID) of the external electronic device 107. For example, the configuration information may indicate whether the external electronic device 107 supports a baseline protocol and/or an extended protocol.

For example, the controller 160 may transition to a power transfer phase 270 based on receiving the packet indicating the identification information and/or the configuration information in the configuration phase 250.

For example, the controller 160 may supply or provide electrical power to the external electronic device 107 during the power transfer phase 270. For example, the controller 160 may supply electrical power obtained from the power supply device 105 to the external electronic device 107 through the wireless power supply circuitry 150, e.g. the electronic device 101 wirelessly supplies power to the external electronic device 107.

For example, the controller 160 may receive a packet from the external electronic device 107 during the power transfer phase 270. For example, the controller 160 may receive a packet from the external electronic device 107 through a communication path based on an in-band or an out-of-band to the external electronic device 107.

For example, a communication path based on the in-band may be a communication path based on a protocol (e.g., the protocol defined in the WPC) for wirelessly supplying electrical power to the external electronic device 107. For example, the communication path based on the in-band may be a communication path through the wireless power supply circuitry 150.

For example, a communication path based on the out-of-band may be a communication path based on another protocol other than the protocol (e.g., the protocol defined in the WPC) for wirelessly supplying electrical power to the external electronic device 107. For example, the communication path based on the out-of-band may be a communication path through communication circuitry other than the wireless power supply circuitry 150. For example, the other protocol other than the protocol (e.g., the protocol defined in the WPC) may be a protocol based on at least one of Bluetooth, Bluetooth low energy, Wi-Fi, and near field communication. However, it is not limited thereto. For example, the electronic device 101 may wirelessly supply power to the external electronic device 107 using a first protocol and may communicate (e.g. for the purpose of transmitting and/or receiving data or messages) with the external electronic device 107 using a second protocol different to the first protocol.

For example, the electronic device 101 may receive a packet from the external electronic device 107 during the power transfer phase 270 indicating a control error, received power, a charge status, end power transfer, and/or renegotiation.

For example, the controller 160 may change electrical power supplied to the external electronic device 107 based on a request from the external electronic device 107. For example, the controller 160 may change the electrical power supplied to the external electronic device 107 based on charging power (a charging voltage and a charging current) required by the external electronic device 107. For example, the controller 160 may change the electrical power (or a power level) supplied to the external electronic device 107 based on a packet received from the external electronic device 107 during the power transfer phase 270. For example, the controller 160 may change the electrical power (or the power level) supplied to the external electronic device 107 based on a control error packet and/or a received power packet received from the external electronic device 107 during the power transfer phase 270. However, it is not limited thereto.

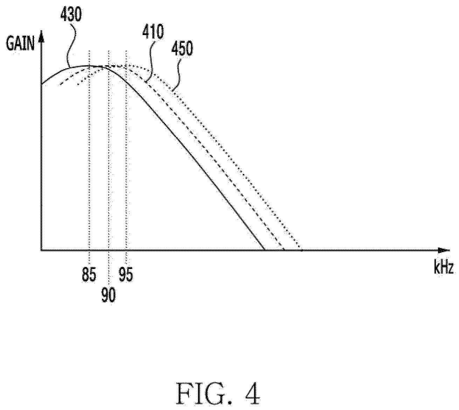

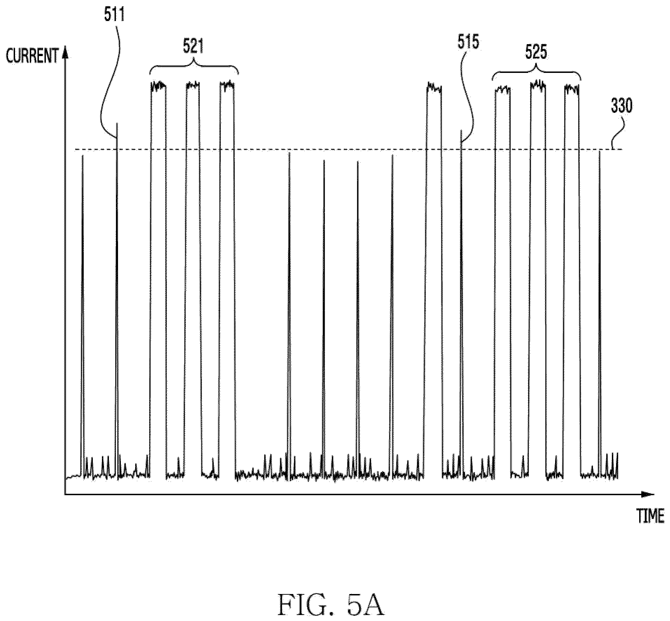

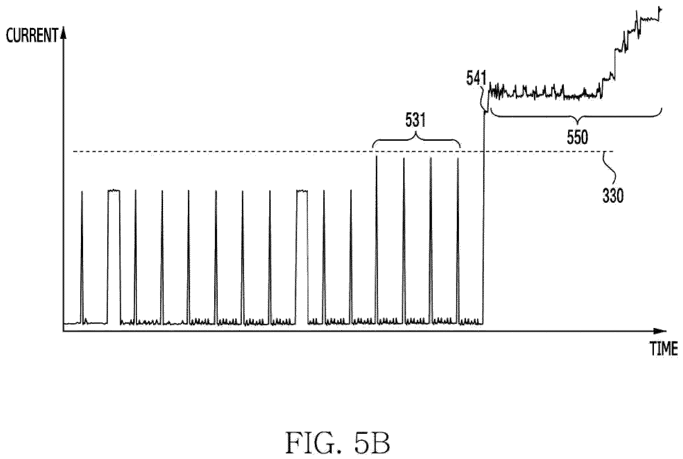

As described above, a performance of the electronic device 101 may vary according to a deviation (e.g., a component deviation of the wireless power supply circuitry 150) of a component of the electronic device 101. For example, according to a component deviation of the capacitor 151 and/or the inductor 155 of the wireless power supply circuitry 150, the resonance frequency of the wireless power supply circuitry 150 may vary. In case that the resonance frequency of the wireless power supply circuitry 150 varies, switching from the selection phase 210 to the ping phase 230 may frequently occur, or switching from the selection phase 210 to the ping phase 230 may not occur. Hereinafter, an error of the electronic device 101 according to the component deviation of the wireless power supply circuitry 150 may be described with reference to FIGS. 4, 5A, and 5B.

FIG. 4 is a diagram exemplifying a graph for a gain according to a frequency. FIG. 5A is a diagram exemplifying an error that may occur in case that a resonance frequency is set high. FIG. 5B is a diagram exemplifying an error that may occur in case that a resonance frequency is set low.

FIGS. 4, 5A, and 5B may be described with reference to FIGS. 1A to 3B.

For example, in case that a capacitor 151 and an inductor 155 of wireless power supply circuitry 150 have a value (e.g., capacitance (e.g., 500 nano-farads (nF)) and inductance (e.g., 6.3 microhenries (uH))) identical to a standard, a curve 410 with the highest gain may be indicated at approximately 90 kilohertz (kHz). In case that each of the capacitor 151 and the inductor 155 of the wireless power supply circuitry 150 has a value approximately 10% higher than the standard, a curve 430 with the highest gain may be indicated at approximately 85 kilohertz (kHz). In case that each of the capacitor 151 and the inductor 155 of the wireless power supply circuitry 150 has a value that is approximately 10% lower than the standard, a curve 450 with the highest gain may be indicated at approximately 95 kilohertz (kHz). Therefore, in case that tolerance (or a component deviation) of the capacitor 151 and the inductor 155 of the wireless power supply circuitry 150 is allowed to be approximately 10%, a resonance frequency (or a frequency indicating the highest gain) of the wireless power supply circuitry 150 may be formed between approximately 85 kilohertz (kHz) and approximately 95 kilohertz (kHz). For example, due to manufacturing limitations in relation to a capacitor 151 and/or an inductor 155 of the wireless power supply circuitry 150, capacitance and inductance values, respectively, for each may vary by up to 10% of a standard value (e.g. set according to a technical standard), which causes a change in the position of the resonance frequency. The change in the resonance frequency is based on the variation or deviation in the capacitance and inductance values from the standard values.

For example, electrical energy (e.g., at least one of current and voltage) measured when transmitting an analog ping during a selection phase 210 may also be changed by the tolerance (or the component deviation) in different ways according to a change in the resonance frequency. For example, even when the inverter 140 operates at the same operating frequency and the same DC voltage is applied to the inverter 140, by (e.g. due to, or based on) the tolerance (or the component deviation), magnitude of electrical power wirelessly transmitted to an external electronic device 107 through the wireless power supply circuitry 150 may vary according to the resonance frequency. In addition, by (e.g. due to, or based on) the tolerance (or the component deviation), a current value of the analog ping transmitted through the wireless power supply circuitry 150 may be changed according to the resonance frequency.

For example, in case of having a relatively high resonance frequency, a current value measured through the wireless power supply circuitry 150 may be relatively high. In case of having the relatively high resonance frequency, the current value of the analog ping transmitted through the wireless power supply circuitry 150 may exceed a threshold current value 330, even in a state in which the external electronic device 107 does not approach an electronic device 101 to wirelessly obtain electrical power from the electronic device 101 (e.g. a state in which the external electronic device 107 is not near or proximate to the electronic device 101, or even not in the surroundings of the electronic device 101). Accordingly, in case of having the relatively high resonance frequency, electrical power for transmitting a digital ping may be wasted as the external electronic device 107 is incorrectly identified as approaching the electronic device 101. For example, this may be a false positive scenario, in which the electronic device 101 falsely detects the presence of the external electronic device 107 via the analog ping(s).

For example, referring to FIG. 5A, a current value of analog pings 511 and 515 transmitted through the wireless power supply circuitry 150 transmitted by the electronic device 101 may exceed the threshold current value 330 in the state in which the external electronic device 107 does not approach the electronic device 101. Accordingly, the electronic device 101 transmits digital pings 521 and 525 through the wireless power supply circuitry 150 even though the external electronic device 107 does not exist, and standby power by the digital pings 521 and 525 (i.e. the power of the digital pings 521 and 525) may be wasted.

For example, in case of having a relatively low resonance frequency, the current value measured through the wireless power supply circuitry 150 may be relatively low. In case of having the relatively low resonance frequency, the current value of the analog ping transmitted through the wireless power supply circuitry 150 may not exceed the threshold current value 330, even in a state in which the external electronic device 107 approaches the electronic device 101 to wirelessly obtain electrical power from the electronic device 101 (e.g. a state in which the external electronic device 107 is near or proximate to the electronic device 101). Accordingly, in case of having the relatively low resonance frequency, identification of the external electronic device 107 may be delayed. For example, this may be a false negative scenario, in which the electronic device 101 fails to detect the presence of the external electronic device 107 via the analog ping(s).

For example, referring to FIG. 5B, a current value of analog pings 531 transmitted through the wireless power supply circuitry 150 transmitted by the electronic device 101 may be higher than a current value of the analog pings 531 transmitted previously, in the state in which the external electronic device 107 approaches the electronic device 101. However, in case that the wireless power supply circuitry 150 has a relatively low resonance frequency, the current value of the analog pings 531 transmitted through the wireless power supply circuitry 150 transmitted by the electronic device 101 may not exceed the threshold current value 330. Accordingly, the electronic device 101 transmits the digital ping 541 to the external electronic device 107 at a relatively late time, and a state change to a configuration phase and/or a power transfer phase 550 for transmitting wireless power may be delayed.

Therefore, despite (or in view of) the component deviation existing according to the tolerance, a method for setting a threshold current value for the electronic device 101 to detect the external electronic device 107 may be required. In other words, a method may be required to set the threshold current value for the electronic device 101 having in mind (i.e. taking into consideration) a difference in a resonance frequency generated by (or caused by, or resulting from etc.) the component deviation existing according to the tolerance.

Hereinafter, an operation in which the electronic device 101 sets a threshold current value will be described with reference to FIGS. 1A to 2.

In an embodiment, the electronic device 101 may identify an event. In an embodiment, the electronic device 101 may identify the event based on transmitting a signal (e.g., an analog ping) for identification of the external electronic device 107. In an embodiment, the electronic device 101 may identify the event during a selection phase. For example, the event may be based on a state of the electronic device 101, a state of the external electronic device 107, and/or a state of a power supply device 105.

For example, the event may include an event in which the electronic device 101 changes (or sets) a threshold current value for identifying the external electronic device 107. For example, the event may include an event identifying that the electronic device 101 is wiredly connected to the power supply device 105 through a hardware interface (e.g., a universal serial bus (USB) interface) (e.g., a connector 110). In various examples, the electronic device 101 identifying an event may be regarded as the electronic device 101 determining or identifying a condition or criteria to be met. For example, identifying the event may refer to the electronic device 101 determining a current phase to be a selection phase or that a (wired) connection to the power supply device 105 is established.

According to an embodiment, the event may be identified after the electronic device 101 initially sets the threshold current value immediately after the wired connection with the power supply device 105. For example, the event may include an event in which the electronic device 101 identifies that a supply of wireless power to the external electronic device 107 is ceased. For example, the event may include an event identifying that the external electronic device 107 is detached (e.g. disconnected, disassociated, taken away etc.) from the electronic device 101. For example, the event may include an event identifying that the electronic device 101 transitions from a phase (e.g., a power transfer phase, or a configuration phase) other than the selection phase to the selection phase.

For example, the event may include an event identifying that the electronic device 101 transitions to the selection phase after the electronic device 101 initially sets the threshold current value. For example, the event may include an event identifying that current values of analog pings transmitted during the selection phase after the electronic device 101 initially sets the threshold current value do not exceed the current threshold current value.

For example, the event may include an event identifying that the electronic device 101 transmits the specified threshold number of analog pings without transitioning from the selection phase to the specified phase (e.g., the power transfer phase, or the configuration phase). Herein, transmitting the specified threshold number of the analog ping may include transmitting analog pings during one selection phase. Transmitting the specified threshold number of the analog ping may include transmitting analog pings during a plurality of selection phases, in an alternating situation between the selection phase and a ping phase.

In an embodiment, the electronic device 101 may identify a representative current value. In an embodiment, the electronic device 101 may identify a representative value of current values of analog pings as the representative current value. In an embodiment, the electronic device 101 may identify an average value of the current values of the analog ping(s) as the representative current value. In an embodiment, the electronic device 101 may identify an average value of current values excluding a maximum value and/or a minimum value from the current values of the analog pings as the representative current value. In an embodiment, the electronic device 101 may identify an average value of the current values of the analog ping(s) that does not exceed a reference threshold current value (e.g., 80 milliamperes) as the representative current value. For example, the average value may be a mean or median value.

For example, the electronic device 101 may identify the representative current value based on current values of the specified number (e.g., six) of analog ping. For example, the electronic device 101 may identify the representative current value based on current values of the specified number (e.g., six) of analog pings continuous (or discontinuous) from a reference analog ping. Herein, discontinuity of analog pings may include inclusion of a different type of ping (e.g., a digital ping) between the discontinuous analog pings. For example, a portion of the specified number of analog pings are transmitted before the transmission of one or more digital pings, and a remaining portion of the specified number of analog pings are transmitted after the transmission of the one or more digital pings.

For example, the electronic device 101 may identify the representative current value based on current values of analog pings transmitted during the specified number of selection phases. For example, the electronic device 101 may identify the representative current value based on the current values of the analog ping transmitted during the specified number of selection phases continuous (or discontinuous) from a reference selection phase. Herein, discontinuity of selection phases may include inclusion of a different type of a phase (e.g., ping phase) between the discontinuous selection phases.

According to an embodiment, the electronic device 101 may identify the representative current value based on current values of analog ping transmitted in a specified time length.

In an embodiment, the electronic device 101 may determine whether the representative current value is within a reference current range. In an embodiment, the reference current range may be predetermined according to a specification of the electronic device 101. For example, the reference current range may be predetermined according to the tolerance of the wireless power supply circuitry 150. For example, in case that the capacitor 151 has capacitance of approximately 500 nano-farads (nF) and the inductor 155 has inductance of approximately 6.3 microhenries (uH), the reference current range may have a range of approximately 50 milliamperes to approximately 100 milliamperes.

For example, in case that the representative current value is within the reference current range, the electronic device 101 may set a first threshold current value. For example, in case that the representative current value is less than a upper limit value (e.g., 100 milliamperes) and greater than a lower limit value (e.g., 50 milliamperes) of the reference current range, the electronic device 101 may set the first threshold current value.

For example, the electronic device 101 may set the first threshold current value based on the representative current value. For example, the electronic device 101 may set a sum of the representative current value and an offset as the first threshold current value. In an embodiment, the offset may be a fixed value. For example, the offset may be predetermined according to a specification of the electronic device 101. For example, the offset may be predetermined according to the tolerance of the wireless power supply circuitry 150. For example, the offset may be 10 milliamperes. For example, the offset may be a positive or negative value.

In an embodiment, in case that the representative current value is outside the reference current range, the electronic device 101 may set a second threshold current value. For example, in case that the representative current value is greater than the upper limit value (e.g., 100 milliamperes) of the reference current range, the electronic device 101 may set the second threshold current value. For example, in case that the representative current value is less than the lower limit value (e.g., 50 milliamperes) of the reference current range, the electronic device 101 may set the second threshold current value.

In an embodiment, the electronic device 101 may set the second threshold current value. For example, the electronic device 101 may set the second threshold current value based on the reference threshold current value (e.g., 80 milliamperes). For example, the electronic device 101 may set the reference threshold current value (e.g., 80 milliamperes) as the second threshold current value.

In an embodiment, the electronic device 101 may set the reference threshold current value. For example, the electronic device 101 may identify the first threshold current value or the second threshold current value as a new reference threshold current value.

In an embodiment, the electronic device 101 may detect the external electronic device 107 based on the reference threshold current value. For example, the electronic device 101 may detect the external electronic device 107 based on comparing a current value of an analog ping transmitted after an operation 650 with the reference threshold current value. According to an embodiment, the electronic device 101 may detect the external electronic device 107 based on the reference threshold current value (e.g., 80 milliamperes) before initially setting the reference threshold current value (e.g., before setting the reference threshold current value through the specified number of analog pings after the electronic device 101 is wiredly connected to the power supply device 105).

For example, the electronic device 101 may transmit a digital ping through the wireless power supply circuitry 150 at a time point of transmitting a next ping (e.g., an analog ping or a digital ping) based on a current value of the transmitted analog ping being greater than the reference threshold current value. For example, the electronic device 101 may transmit an analog ping again through the wireless power supply circuitry 150 at a time point of transmitting a next ping (e.g., an analog ping or a digital ping) based on the current value of the transmitted analog ping being less than or equal to the reference threshold current value.

As described above, the electronic device 101 may reduce a situation in which standby power is wasted (e.g. the power inherent in the digital ping is wasted) according to the resonance frequency of the wireless power supply circuitry 150 by the component deviation according to the tolerance. The electronic device 101 may reduce a situation in which time required to detect the external electronic device 107 increases according to the resonance frequency of the wireless power supply circuitry 150 by the component deviation according to the tolerance. That is, examples of the present disclosure may reduce a number of false positives and/or reduce a number of false negatives, where this may be achieved by adaptively setting a threshold current (or voltage) value through monitoring and averaging values of one or more analog pings and, if the averaged value falls outside a predetermined range, by setting the threshold current (or voltage) to a default or predetermined value as opposed to setting the threshold current (or voltage) to (or based on) the averaged value.

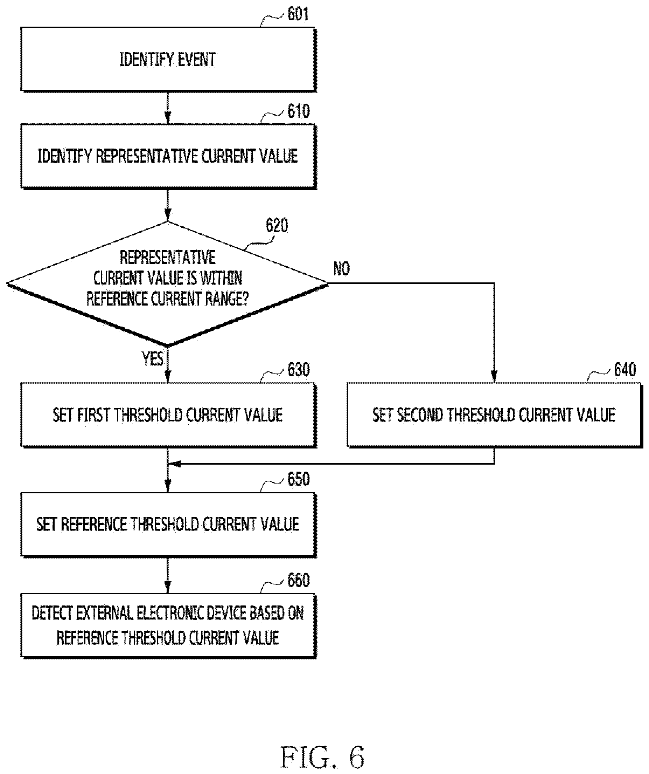

Hereinafter, an operation in which the electronic device 101 sets a threshold current value will be described with reference to FIG. 6.

FIG. 6 is a flowchart exemplifying an operation of an electronic device according to an embodiment.

FIG. 6 may be described with reference to FIGS. 1A to 3B. Operations of FIG. 6 may be performed by an electronic device 101 or a controller 160 of the electronic device 101.

In the following embodiment, each of the operations may be sequentially performed, but is not necessarily performed sequentially. For example, an order of each of the operations may be changed, and at least two operations may be performed in parallel. Furthermore, one or more operations can be combined. Also, if two or more operations are described as alternatives to one another (e.g. different outcomes for a specific operation), it will be understood that the present disclosure includes examples in which only one, or a subset, of the two or more operations are included (e.g. it may not be essential to recite all outcomes of an operation together, but rather only one outcome may be included).

The operations of FIG. 6 may be repeatedly performed. For example, operations 610 to 660 of FIG. 6 may be performed based on identification of an event according to an operation 601. For example, as the operations of FIG. 6 are repeatedly performed, a reference threshold current value may be changed. However, it is not limited thereto. For example, the operations of FIG. 6 may be performed only once. For example, the operations of FIG. 6 may be performed once based on one event (e.g., an event in which a connection between the electronic device 101 and a power supply device 105 is identified). Accordingly, as the operations of operation 6 are performed once, the reference threshold current value may not be changed.

Referring to FIG. 6, in the operation 601, electronic device 101 may identify an event. In an embodiment, the electronic device 101 may identify the event based on transmitting a signal (e.g., an analog ping) for identifying an external electronic device 107. In an embodiment, the electronic device 101 may identify the event during a selection phase. For example, the event may be based on a state of the electronic device 101, a state of the external electronic device 107, and/or a state of the power supply device 105. In various examples, identification of an event corresponds to a trigger, i.e. the electronic device 101 determines a condition or criteria is met such that a corresponding operation is performed (i.e. triggered).

For example, the event may include an event in which the electronic device 101 changes (or sets) a threshold current value for identifying the external electronic device 107. For example, the event may include an event identifying that the electronic device 101 is wiredly connected to the power supply device 105 through a hardware interface (e.g., a USB interface) (e.g., a connector 110).

According to an embodiment, the event may be identified after the electronic device 101 initially sets the reference threshold current value immediately after the wired connection with the power supply device 105. For example, the event may include an event in which the electronic device 101 identifies that a supply of wireless power to the external electronic device 107 is ceased. For example, the event may include an event identifying that the external electronic device 107 is detached from the electronic device 101. For example, the event may include an event identifying that the electronic device 101 transitions from a phase (e.g., a power transfer phase, or a configuration phase) other than the selection phase to the selection phase.

For example, the event may include an event identifying that the electronic device 101 transitions to the selection phase after the electronic device 101 initially sets the reference threshold current value. For example, the event may include an event identifying that current values of analog pings transmitted during the selection phase after the electronic device 101 initially sets the reference threshold current value do not exceed a present reference threshold current value.

For example, the event may include an event identifying that the electronic device 101 transmits the specified threshold number of analog pings without transitioning from the selection phase to the specified phase (e.g., the power transfer phase, or the configuration phase). Herein, transmitting the specified threshold number of the analog ping may include transmitting analog pings during one selection phase. Transmitting the specified threshold number of the analog ping may include transmitting analog pings during a plurality of selection phases, in an alternating situation between the selection phase and a ping phase. Operation 601 may be omitted in various examples of the present disclosure.

In the operation 610, the electronic device 101 may identify a representative current value. In an embodiment, the electronic device 101 may identify a representative value of current values of analog pings as the representative current value. In an embodiment, the electronic device 101 may identify an average value of the current values of the analog ping as the representative current value. In an embodiment, the electronic device 101 may identify an average value of current values excluding a maximum value and/or a minimum value from the current values of the analog pings as the representative current value. In an embodiment, the electronic device 101 may identify an average value of the current values of the analog ping that does not exceed a reference threshold current value (e.g., 80 milliamperes) as the representative current value.

For example, the electronic device 101 may identify the representative current value based on current values of the specified number (e.g., six) of analog ping. For example, the electronic device 101 may identify the representative current value based on current values of the specified number (e.g., six) of analog pings continuous (or discontinuous) from a reference analog ping. Herein, discontinuity of analog pings may include inclusion of a different type of ping (e.g., a digital ping) between the discontinuous analog pings. For example, continuous analog pings may refer to analog pings transmitted one after the other, without interruption; while discontinuous analog pings may refer to a number of analog pings which are not transmitted one after another but instead there exists some intervening ping(s) transmitted between a consecutive two or more of the number of analog pings.

For example, the electronic device 101 may identify the representative current value based on current values of analog pings transmitted during the specified number of selection phases. For example, the electronic device 101 may identify the representative current value based on the current values of the analog ping transmitted during the specified number of selection phases continuous (or discontinuous) from a reference selection phase. Herein, discontinuity of selection phases may include inclusion of a different type of a phase (e.g., ping phase) between the discontinuous selection phases. For example, continuous selection phases may refer to selection phases occurring one after the other, without interruption; while discontinuous selection phases may refer to a number of selection phases which are do not occur one after another but instead there exists some intervening phase(s) (e.g. ping phase) occurring between a consecutive two or more of the number of selection phases.

According to an embodiment, the electronic device 101 may identify the representative current value based on current values of analog ping transmitted in a specified time length or interval.

In an operation 620, the electronic device 101 may determine whether the representative current value is within a reference current range (or, more generally, a range or range of values). In an embodiment, the reference current range may be predetermined according to a specification of the electronic device 101. For example, the reference current range may be predetermined according to tolerance of wireless power supply circuitry 150. For example, the reference current range may be set based on a characteristic (e.g. capacitance or inductance) of the capacitor 151 and/or the inductor 155. For example, in case that a capacitor 151 has capacitance of approximately 500 nano-farads (nF) and an inductor 155 has inductance of approximately 6.3 microhenries (uH), the reference current range may have a range of approximately 50 milliamperes to approximately 100 milliamperes.

In the operation 620, in case that the representative current value is within the reference current range, the electronic device 101 may perform an operation 630. For example, in case that the representative current value is less than a upper limit value (e.g., 100 milliamperes) and greater than a lower limit value (e.g., 50 milliamperes) of the reference current range, the electronic device 101 may perform the operation 630. In the operation 620, in case that the representative current value is outside the reference current range, the electronic device 101 may perform an operation 640. For example, in case that the representative current value is greater than the upper limit value (e.g., 100 milliamperes) of the reference current range, the electronic device 101 may perform the operation 640. For example, in case that the representative current value is less than the lower limit value (e.g., 50 milliamperes) of the reference current range, the electronic device 101 may perform the operation 640.

In the operation 630, the electronic device 101 may set a first threshold current value. For example, the electronic device 101 may set the first threshold current value based on the representative current value. For example, the electronic device 101 may set a sum of the representative current value and an offset as the first threshold current value, or may set the representative current value as the first threshold current value. In an embodiment, the offset may be a fixed value, e.g. either positive or negative. For example, the offset may be predetermined according to a specification of the electronic device 101. For example, the offset may be predetermined according to the tolerance of the wireless power supply circuitry 150. For example, the offset may be 10 milliamperes.

In the operation 640, the electronic device 101 may set a second threshold current value. For example, the electronic device 101 may set the second threshold current value based on the reference threshold current value (e.g., 80 milliamperes). For example, the electronic device 101 may set the reference threshold current value (e.g., 80 milliamperes) as the second threshold current value.

In an embodiment, the electronic device 101 may set the reference threshold current value. For example, the electronic device 101 may identify the first threshold current value or the second threshold current value as a new reference threshold current value.

In an embodiment, the electronic device 101 may detect the external electronic device 107 based on the reference threshold current value. For example, the electronic device 101 may detect the external electronic device 107 based on comparing a current value of an analog ping transmitted after an operation 650 with the reference threshold current value.

For example, the electronic device 101 may transmit a digital ping through the wireless power supply circuitry 150 at a time point of transmitting a next ping (e.g., an analog ping or a digital ping) based on a current value of the analog ping transmitted after the operation 650 being greater than the reference threshold current value. For example, the electronic device 101 may transmit an analog ping again through the wireless power supply circuitry 150 at a time point of transmitting a next ping (e.g., an analog ping or a digital ping) based on the current value of the analog ping transmitted after the operation 650 being less than or equal to the reference threshold current value.

FIG. 7 is a block diagram of an electronic device in a network environment according to various embodiments.

Referring to FIG. 7, the electronic device 701 in the network environment 700 may communicate with an electronic device 702 via a first network 798 (e.g., a short-range wireless communication network), or at least one of an electronic device 704 or a server 708 via a second network 799 (e.g., a long-range wireless communication network). According to an embodiment, the electronic device 701 may communicate with the electronic device 704 via the server 708. According to an embodiment, the electronic device 701 may include a processor 720, memory 730, an input module 750, a sound output module 755, a display module 760, an audio module 770, a sensor module 776, an interface 777, a connecting terminal 778, a haptic module 779, a camera module 780, a power management module 788, a battery 789, a communication module 790, a subscriber identification module(SIM) 796, or an antenna module 797. In some embodiments, at least one of the components (e.g., the connecting terminal 778) may be omitted from the electronic device 701, or one or more other components may be added in the electronic device 701. In some embodiments, some of the components (e.g., the sensor module 776, the camera module 780, or the antenna module 797) may be implemented as a single component (e.g., the display module 760).

The processor 720 may execute, for example, software (e.g., a program 740) to control at least one other component (e.g., a hardware or software component) of the electronic device 701 coupled with the processor 720, and may perform various data processing or computation. According to an embodiment, as at least part of the data processing or computation, the processor 720 may store a command or data received from another component (e.g., the sensor module 776 or the communication module 790) in volatile memory 732, process the command or the data stored in the volatile memory 732, and store resulting data in non-volatile memory 734. According to an embodiment, the processor 720 may include a main processor 721 (e.g., a central processing unit (CPU) or an application processor (AP)), or an auxiliary processor 723 (e.g., a graphics processing unit (GPU), a neural processing unit (NPU), an image signal processor (ISP), a sensor hub processor, or a communication processor (CP)) that is operable independently from, or in conjunction with, the main processor 721. For example, when the electronic device 701 includes the main processor 721 and the auxiliary processor 723, the auxiliary processor 723 may be adapted to consume less power than the main processor 721, or to be specific to a specified function. The auxiliary processor 723 may be implemented as separate from, or as part of the main processor 721.

The auxiliary processor 723 may control at least some of functions or states related to at least one component (e.g., the display module 760, the sensor module 776, or the communication module 790) among the components of the electronic device 701, instead of the main processor 721 while the main processor 721 is in an inactive (e.g., sleep) state, or together with the main processor 721 while the main processor 721 is in an active state (e.g., executing an application). According to an embodiment, the auxiliary processor 723 (e.g., an image signal processor or a communication processor) may be implemented as part of another component (e.g., the camera module 780 or the communication module 790) functionally related to the auxiliary processor 723. According to an embodiment, the auxiliary processor 723 (e.g., the neural processing unit) may include a hardware structure specified for artificial intelligence model processing. An artificial intelligence model may be generated by machine learning. Such learning may be performed, e.g., by the electronic device 701 where the artificial intelligence is performed or via a separate server

(e.g., the server 708). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 730 may store various data used by at least one component (e.g., the processor 720 or the sensor module 776) of the electronic device 701. The various data may include, for example, software (e.g., the program 740) and input data or output data for a command related thereto. The memory 730 may include the volatile memory 732 or the non-volatile memory 734.

The program 740 may be stored in the memory 730 as software, and may include, for example, an operating system (OS) 742, middleware 744, or an application 746.

The input module 750 may receive a command or data to be used by another component (e.g., the processor 720) of the electronic device 701, from the outside (e.g., a user) of the electronic device 701. The input module 750 may include, for example, a microphone, a mouse, a keyboard, a key (e.g., a button), or a digital pen (e.g., a stylus pen).

The sound output module 755 may output sound signals to the outside of the electronic device 701. The sound output module 755 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 760 may visually provide information to the outside (e.g., a user) of the electronic device 701. The display module 760 may include, for example, a display, a hologram device, or a projector and control circuitry to control a corresponding one of the display, hologram device, and projector. According to an embodiment, the display module 760 may include a touch sensor adapted to detect a touch, or a pressure sensor adapted to measure the intensity of force incurred by the touch.

The audio module 770 may convert a sound into an electrical signal and vice versa. According to an embodiment, the audio module 770 may obtain the sound via the input module 750, or output the sound via the sound output module 755 or a headphone of an external electronic device (e.g., an electronic device 702) directly (e.g., wiredly) or wirelessly coupled with the electronic device 701.

The sensor module 776 may detect an operational state (e.g., power or temperature) of the electronic device 701 or an environmental state (e.g., a state of a user) external to the electronic device 701, and then generate an electrical signal or data value corresponding to the detected state. According to an embodiment, the sensor module 776 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 777 may support one or more specified protocols to be used for the electronic device 701 to be coupled with the external electronic device (e.g., the electronic device 702) directly (e.g., wiredly) or wirelessly. According to an embodiment, the interface 777 may include, for example, a high definition multimedia interface (HDMI), a universal serial bus (USB) interface, a secure digital (SD) card interface, or an audio interface.

A connecting terminal 778 may include a connector via which the electronic device 701 may be physically connected with the external electronic device (e.g., the electronic device 702). According to an embodiment, the connecting terminal 778 may include, for example, an HDMI connector, a USB connector, a SD card connector, or an audio connector (e.g., a headphone connector).

The haptic module 779 may convert an electrical signal into a mechanical stimulus (e.g., a vibration or a movement) or electrical stimulus which may be recognized by a user via his tactile sensation or kinesthetic sensation. According to an embodiment, the haptic module 779 may include, for example, a motor, a piezoelectric element, or an electric stimulator.

The camera module 780 may capture a still image or moving images. According to an embodiment, the camera module 780 may include one or more lenses, image sensors, image signal processors, or flashes.

The power management module 788 may manage power supplied to the electronic device 701. According to an embodiment, the power management module 788 may be implemented as at least part of, for example, a power management integrated circuit (PMIC).

The battery 789 may supply power to at least one component of the electronic device 701. According to an embodiment, the battery 789 may include, for example, a primary cell which is not rechargeable, a secondary cell which is rechargeable, or a fuel cell.

The communication module 790 may support establishing a direct (e.g., wired) communication channel or a wireless communication channel between the electronic device 701 and the external electronic device (e.g., the electronic device 702, the electronic device 704, or the server 708) and performing communication via the established communication channel. The communication module 790 may include one or more communication processors that are operable independently from the processor 720 (e.g., the application processor (AP)) and supports a direct (e.g., wired) communication or a wireless communication. According to an embodiment, the communication module 790 may include a wireless communication module 792 (e.g., a cellular communication module, a short-range wireless communication module, or a global navigation satellite system (GNSS) communication module) or a wired communication module 794 (e.g., a local area network (LAN) communication module or a power line communication (PLC) module). A corresponding one of these communication modules may communicate with the external electronic device via the first network 798 (e.g., a short-range communication network, such as Bluetooth^{™}, wireless-fidelity (Wi-Fi) direct, or infrared data association (IrDA)) or the second network 799 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 792 may identify and authenticate the electronic device 701 in a communication network, such as the first network 798 or the second network 799, using subscriber information (e.g., international mobile subscriber identity (IMSI)) stored in the subscriber identification module 796.

The wireless communication module 792 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 792 may support a high-frequency band (e.g., the mmWave band) to achieve, e.g., a high data transmission rate. The wireless communication module 792 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 792 may support various requirements specified in the electronic device 701, an external electronic device (e.g., the electronic device 704), or a network system (e.g., the second network 799). According to an embodiment, the wireless communication module 792 may support a peak data rate (e.g., 20Gbps or more) for implementing eMBB, loss coverage (e.g., 764dB or less) for implementing mMTC, or U-plane latency (e.g., 0.5ms or less for each of downlink (DL) and uplink (UL), or a round trip of 7ms or less) for implementing URLLC.

The antenna module 797 may transmit or receive a signal or power to or from the outside (e.g., the external electronic device) of the electronic device 701. According to an embodiment, the antenna module 797 may include an antenna including a radiating element composed of a conductive material or a conductive pattern formed in or on a substrate (e.g., a printed circuit board (PCB)). According to an embodiment, the antenna module 797 may include a plurality of antennas (e.g., array antennas). In such a case, at least one antenna appropriate for a communication scheme used in the communication network, such as the first network 798 or the second network 799, may be selected, for example, by the communication module 790 (e.g., the wireless communication module 792) from the plurality of antennas. The signal or the power may then be transmitted or received between the communication module 790 and the external electronic device via the selected at least one antenna. According to an embodiment, another component (e.g., a radio frequency integrated circuit (RFIC)) other than the radiating element may be additionally formed as part of the antenna module 797.

According to various embodiments, the antenna module 797 may form a mmWave antenna module. According to an embodiment, the mmWave antenna module may include a printed circuit board, an RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 701 and the external electronic device 704 via the server 708 coupled with the second network 799. Each of the electronic devices 702 or 704 may be a device of a same type as, or a different type, from the electronic device 701. According to an embodiment, all or some of operations to be executed at the electronic device 701 may be executed at one or more of the external electronic devices 702, 704, or 708. For example, if the electronic device 701 should perform a function or a service automatically, or in response to a request from a user or another device, the electronic device 701, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 701. The electronic device 701 may provide the outcome, with or without further processing of the outcome, as at least part of a reply to the request. To that end, a cloud computing, distributed computing, mobile edge computing (MEC), or client-server computing technology may be used, for example. The electronic device 701 may provide ultra low-latency services using, e.g., distributed computing or mobile edge computing. In another embodiment, the external electronic device 704 may include an internet-of-things (IoT) device. The server 708 may be an intelligent server using machine learning and/or a neural network. According to an embodiment, the external electronic device 704 or the server 708 may be included in the second network 799. The electronic device 701 may be applied to intelligent services (e.g., smart home, smart city, smart car, or healthcare) based on 5G communication technology or IoT-related technology.

As described above, an electronic device 101 may comprise a converter 130 configured to obtain electrical power from power supply circuitry 105, and output the electrical power as direct current (DC) power. The electronic device 101 may comprise an inverter 140 configured to obtain the direct current power from the converter 130, and output the direct current power as alternating current (AC) power. The electronic device 101 may comprise wireless power supply circuitry 150 configured to wirelessly supply, to an external electronic device 107, the AC power of the inverter 140. The electronic device 101 may comprise a controller 160 comprising processing circuitry. The controller 160 may be configured to transmit, through the wireless power supply circuitry 150, first analog pings with a first duration length at a predetermined time interval. The controller 160 may be configured to identify first currents of the first analog pings. The controller 160 may be configured to identify a reference current based on the first currents. The controller 160 may be configured to transmit, through the wireless power supply circuitry 150, a second analog ping with the first duration length. The controller 160 may be configured to identify a second current of the second analog ping. The controller 160 may be configured to, based on the second current exceeding the reference current, transmit, through the wireless power supply circuitry 150, a digital ping with a second duration length longer than the first duration length after the second analog ping. The controller 160 may be configured to, based on the second current being less than or equal to the reference current, transmit, through the wireless power supply circuitry 150, a third analog ping with the first duration length after the second analog ping.

The controller 160 may be configured to identify a connection with the power supply circuitry 105. The controller 160 may be configured to identify the first currents of the first analog pings, including an analog ping initially transmitted after the connection and a specified number of analog pings transmitted sequentially after the analog ping initially transmitted after the connection.

The controller 160 may be configured to, based on a representative current of the first currents being outside a reference current range, identify a predetermined current as the reference current. The controller 160 may be configured to, based on the representative current being within the reference current range, identify a current based on the representative current as the reference current.

The current based on the representative current may correspond to a sum of the representative current and an offset.

The representative current may be an average current of the first currents.

The current based on the representative current, and the predetermined current may have a value within the reference current range.

The representative current may be an average current of currents excluding a maximum current and a minimum current from the first currents.

The controller 160 may be configured to, after identifying the reference current, identify an event. The controller 160 may be configured to adjust the reference current based on currents of other analog pings transmitted after the event is identified.

The controller 160 may be configured to identify a response to the digital ping through the wireless power supply circuitry 150. The controller 160 may be configured to, based on identifying the response, wirelessly supply electrical power to the external electronic device 107 through the wireless power supply circuitry 150. The controller 160 may be configured to, after wirelessly supplying the electrical power to the external electronic device 107, identify the event based on identifying that the external electronic device 107 is detached.

The controller 160 may be configured to, after identifying the reference current, identify the event based on currents of analog pings transmitted during a specified time period not exceeding the reference current.

As described above, a method may be performed by an electronic device 101 including a converter 130 configured to obtain electrical power from power supply circuitry 105, and output the electrical power as direct current (DC) power, an inverter 140 configured to obtain the direct current power from the converter 130, and output the direct current power as alternating current (AC) power, and wireless power supply circuitry 150 configured to wirelessly supply, to an external electronic device 107, the AC power of the inverter 140. The method may comprise transmitting, through the wireless power supply circuitry 150, first analog pings with a first duration length at a predetermined time interval. The method may comprise identifying first currents of the first analog pings. The method may comprise identifying a reference current based on the first currents. The method may comprise transmitting, through the wireless power supply circuitry 150, a second analog ping with the first duration length. The method may comprise identifying a second current of the second analog ping. The method may comprise, based on the second current exceeding the reference current, transmitting, through the wireless power supply circuitry 150, a digital ping with a second duration length longer than the first duration length after the second analog ping. The method may comprise, based on the second current being less than or equal to the reference current, transmitting, through the wireless power supply circuitry 150, a third analog ping with the first duration length after the second analog ping.

The method may comprise identifying a connection with the power supply circuitry 105. The method may comprise identifying the first currents of the first analog pings, including an analog ping initially transmitted after the connection and a specified number of analog pings transmitted sequentially after the analog ping initially transmitted after the connection.

The method may comprise, based on a representative current of the first currents being outside a reference current range, identifying a predetermined current as the reference current. The method may comprise, based on the representative current being within the reference current range, identifying a current based on the representative current as the reference current.

The current based on the representative current may correspond to a sum of the representative current and an offset.

The representative current may be an average current of the first currents.

The current based on the representative current, and the predetermined current may have a value within the reference current range.

The representative current may be an average current of currents excluding a maximum current and a minimum current from the first currents.

The method may comprise, after identifying the reference current, identifying an event. The method may comprise adjusting the reference current based on currents of other analog pings transmitted after the event is identified.

The method may comprise identifying a response to the digital ping through the wireless power supply circuitry 150. The method may comprise, based on identifying the response, wirelessly supplying electrical power to the external electronic device 107 through the wireless power supply circuitry 150. The method may comprise, after wirelessly supplying the electrical power to the external electronic device 107, identifying the event based on identifying that the external electronic device 107 is detached.

The method may comprise after identifying the reference current, identifying the event based on currents of analog pings transmitted during a specified time period not exceeding the reference current.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," or "connected with" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 740) including one or more instructions that are stored in a storage medium (e.g., internal memory 736 or external memory 738) that is readable by a machine (e.g., the electronic device 701). For example, a processor (e.g., the processor 720) of the machine (e.g., the electronic device 701) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between a case in which data is semi-permanently stored in the storage medium and a case in which the data is temporarily stored in the storage medium. For example, a device (e.g. electronic device 101, 700) may comprise at least one processor (e.g. processor 720) and memory comprising instructions which, when executed by the at least one processor individually or collectively, causes the device or at least one processor to perform a method according to any one or more of the examples disclosed herein.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

It will also be appreciated that certain aspects and embodiments of the invention provide subject matter in accordance with the following numbered paragraphs:
Paragraph 1. An electronic device comprising: wireless power supply circuitry configured to wirelessly supply power, and a controller comprising processing circuitry, and configured to: transmit (e.g. through the wireless power supply circuitry) first analog pings in a predetermined time interval, the first analog pings each having a first duration; identify a representative current value based on first current values of the first analog pings; identify a reference current value based on the representative current value( and a reference current range); transmit (e.g. through the wireless power supply circuitry) a second analog ping having the first duration; identify a second current value of the second analog ping; based on the second current value exceeding the reference current value, transmit (e.g. through the wireless power supply circuitry) a digital ping with a second duration longer than the first duration; and based on the second current value being less than or equal to the reference current value, transmit (e.g. through the wireless power supply circuitry) a third analog ping with the first duration.
Paragraph 2. The electronic device of Paragraph 1, wherein the controller is configured to: identify a connection to a power supply, wherein the electronic device is configured to obtain power from the power supply; and identify the first current values of the first analog pings, the first analog pings including an initial analog ping transmitted subsequently to identifying the connection and a specified number of analog pings transmitted sequentially after the initial analog ping.
Paragraph 3. The electronic device of Paragraph 1 or Paragraph 2, wherein the controller is configured to: based on the representative current value being outside the reference current range, identify a predetermined current value as the reference current value; and based on the representative current value being within the reference current range, identify a third current value based on the representative current value as the reference current value.
Paragraph 4. The electronic device of Paragraph 3, wherein one or more of: the third current value corresponds to a sum of the representative current value and an offset; the representative current value is an average of the first current values; the third current value and the predetermined current value have a value within the reference current range; or the representative current value is an average of the first current values excluding a maximum current value and a minimum current value from the first current values.
Paragraph 5. The electronic device of any one of Paragraphs 1 to 4, wherein the controller is configured to: after identifying the reference current value, identify an event; and adjust the reference current value based on fourth current values of one or more fourth analog pings transmitted after the event is identified.
Paragraph 6. The electronic device of Paragraph 5, wherein the controller is configured to: receive a response to the transmitted digital ping; based on receiving the response, wirelessly supply electrical power to an external electronic device through the wireless power supply circuitry; and identify the event based on identifying that the wireless supplying of the electrical power to the external electronic device ceases.
Paragraph 7. The electronic device of Paragraph 5, wherein the controller is configured to: after identifying the reference current value, identify the event based on current values of a plurality of analog pings, including the second analog ping , transmitted during a specified time period not exceeding the reference current value.
Paragraph 8. The electronic device of any one of Paragraphs 5 to 7, wherein the controller is configured to: adjust the reference current value based on another representative current value and the reference current range, wherein the another representative current value is identified based on the fourth current values.
Paragraph 9. A method of an electronic device including wireless power supply circuitry configured to wirelessly supply power, the method comprising: transmitting (e.g. through the wireless power supply circuitry) first analog pings in a predetermined time interval, the first analog pings each having a first duration; identifying a representative current value based on first current values of the first analog pings; identifying a reference current value based on the representative current value( and a reference current range); transmitting (e.g. through the wireless power supply circuitry) a second analog ping having the first duration; identifying a second current value of the second analog ping; based on the second current value exceeding the reference current value, transmitting (e.g. through the wireless power supply circuitry) a digital ping with a second duration longer than the first duration; and based on the second current value being less than or equal to the reference current value, transmitting (e.g. through the wireless power supply circuitry) a third analog ping with the first duration.
Paragraph 10. The method of Paragraph 9, comprising: identifying a connection to a power supply, wherein the electronic device is configured to obtain power form the power supply; and identifying the first current values of the first analog pings, the first analog pings including an initial analog ping transmitted subsequently to identifying the connection and a specified number of analog pings transmitted sequentially after the initial analog ping.
Paragraph 11. The method of Paragraph 9 or Paragraph 10, comprising: based on the representative current value being outside the reference current range, identifying a predetermined current value as the reference current value; and based on the representative current value being within the reference current range, identifying a third current value based on the representative current value as the reference current value.
Paragraph 12. The method of Paragraph 11, wherein one or more of: the third current value corresponds to a sum of the representative current value and an offset; the representative current value is an average of the first current values; the third current value and the predetermined current value have a value within the reference current range; or the representative current value is an average of the first current values excluding a maximum current value and a minimum current value from the first current values.
Paragraph 13. The method of any one of Paragraphs 9 to 12, comprising: after identifying the reference current value, identifying an event; and adjusting the reference current value based on current values of one or more fourth analog pings transmitted after the event is identified.
Paragraph 14. The method of Paragraph 13, comprising: receiving a response to the digital ping; based on receiving the response, wirelessly supplying electrical power to an external electronic device through the wireless power supply circuitry; and identifying the event based on identifying that the wireless supplying of the electrical power to the external electronic device ceases.
Paragraph 15. The method of Paragraph 13, comprising: after identifying the reference current value, identifying the event based on current values of a plurality of analog pings transmitted during a specified time period not exceeding the reference current value.

## Claims

1. An electronic device comprising:
wireless power supply circuitry (150) configured to wirelessly supply power, and
a controller (160) comprising processing circuitry, and configured to:
transmit, through the wireless power supply circuitry (150), first analog pings in a predetermined time interval, the first analog pings each having a first duration,
identify a representative current value based on first current values of the first analog pings,
identify a reference current value based on the representative current value,
transmit, through the wireless power supply circuitry, a second analog ping having the first duration,
identify a second current value of the second analog ping,
based on the second current value exceeding the reference current value, transmit, through the wireless power supply circuitry (150), a digital ping with a second duration longer than the first duration, and
based on the second current value being less than or equal to the reference current value, transmit, through the wireless power supply circuitry (150), a third analog ping with the first duration.

2. The electronic device of claim 1,
wherein the controller (160) is configured to:
identify a connection to a power supply circuitry (105), wherein the electronic device is configured to obtain power from the power supply circuitry, and
identify the first current values of the first analog pings, the first analog pings including an initial analog ping transmitted subsequently to identifying the connection and a specified number of analog pings transmitted sequentially after the initial analog ping.

3. The electronic device of claim 1 or claim 2,
wherein the controller (160) is configured to:
based on the representative current value being outside a reference current range, identify a predetermined current value as the reference current value, and
based on the representative current value being within the reference current range, identify a third current value based on the representative current value as the reference current value.

4. The electronic device of claim 3, wherein one or more of:
the third current value corresponds to a sum of the representative current value and an offset;
the representative current value is an average of the first current values;
the third current value and the predetermined current value have a value within the reference current range; or
the representative current value is an average of the first current values excluding a maximum current value and a minimum current value from the first current values.

5. The electronic device of any one of the previous claims,
wherein the controller (160) is configured to:
after identifying the reference current value, identify an event, and
adjust the reference current value based on fourth current values of one or more fourth analog pings transmitted after the event is identified.

6. The electronic device of claim 5,
wherein the controller (160) is configured to:
receive a response to the transmitted digital ping,
based on receiving the response, wirelessly supply electrical power to an external electronic device (107) through the wireless power supply circuitry (150), and
identify the event based on identifying that the wireless supplying of the electrical power to the external electronic device (107) ceases.

7. The electronic device of claim 5,
wherein the controller (160) is configured to:
after identifying the reference current value, identify the event based on current values of a plurality of analog pings, including the second analog ping, transmitted during a specified time period not exceeding the reference current value.

8. The electronic device of any one of claims 5 to 7,
wherein the controller (160) is configured to:
adjust the reference current value based on another representative current value and the reference current range, wherein the another representative current value is identified based on the fourth current values.

9. A method of an electronic device including wireless power supply circuitry (150) configured to wirelessly supply power, the method comprising:
transmitting, through the wireless power supply circuitry (150), first analog pings in a predetermined time interval, the first analog pings each having a first duration,
identifying a representative current value based on first current values of the first analog pings,
identifying a reference current value based on the representative current value, transmitting, through the wireless power supply circuitry (150), a second analog ping having the first duration,
identifying a second current value of the second analog ping,
based on the second current value exceeding the reference current value, transmitting, through the wireless power supply circuitry (150), a digital ping with a second duration longer than the first duration, and
based on the second current value being less than or equal to the reference current value, transmitting, through the wireless power supply circuitry (150), a third analog ping with the first duration.

10. The method of claim 9, comprising:
identifying a connection to a power supply circuitry (105), wherein the electronic device is configured to obtain power form the power supply, and
identifying the first current values of the first analog pings, the first analog pings including an initial analog ping transmitted subsequently to identifying the connection and a specified number of analog pings transmitted sequentially after the initial analog ping.

11. The method of claim 9 or claim 10, comprising:
based on the representative current value being outside a reference current range, identifying a predetermined current value as the reference current value, and
based on the representative current value being within the reference current range, identifying a third current value based on the representative current value as the reference current value.

12. The method of claim 11, wherein one or more of:
the third current value corresponds to a sum of the representative current value and an offset;
the representative current value is an average of the first current values;
the third current value and the predetermined current value have a value within the reference current range; or
the representative current value is an average of the first current values excluding a maximum current value and a minimum current value from the first current values.

13. The method of any one of claims 9 to 12, comprising:
after identifying the reference current value, identifying an event, and
adjusting the reference current value based on current values of one or more fourth analog pings transmitted after the event is identified.

14. The method of claim 13, comprising:
receiving a response to the digital ping,
based on receiving the response, wirelessly supplying electrical power to an external electronic device (107) through the wireless power supply circuitry (150), and
identifying the event based on identifying that the wireless supplying of the electrical power to the external electronic device (107) ceases.

15. The method of claim 13, comprising:
after identifying the reference current value, identifying the event based on current values of a plurality of analog pings transmitted during a specified time period not exceeding the reference current value.
